Europäisches Patentamt

European Patent Office

Office européen des brevets

(11) Veröffentlichungsnummer: **0 132 749**
**A2**

# (12) EUROPÄISCHE PATENTANMELDUNG

(21) Anmeldenummer: **84108364.5**

(22) Anmeldetag: **16.07.84**

(51) Int. Cl.⁴: **H 03 B 5/12**
**H 03 C 3/14**

(30) Priorität: **22.07.83 DE 3326382**

(43) Veröffentlichungstag der Anmeldung:
**13.02.85 Patentblatt 85/7**

(84) Benannte Vertragsstaaten:
**AT BE CH DE FR GB IT LI NL**

(71) Anmelder: **Siemens Aktiengesellschaft
Berlin und München Wittelsbacherplatz 2
D-8000 München 2(DE)**

(72) Erfinder: **Thanhäuser, Erhard, Dipl.-Ing.
Mozartstrasse 9
D-8905 Mering(DE)**

(54) **Nachstimmbarer LC-Oszillator mit spannungsgesteuerter Reaktanz.**

(57) Signalverarbeitende Phasenregelschaltungen zur Erzeugung von Trägersignalen verwenden als spannungsgesteuerte Oszillatoren in der Regel solche mit einer Kapazitätsdiode. Im Frequenzbereich von einigen hundert KHz bis zu einigen MHz ergeben sich bei Verwendung von Kapazitätsdioden auch mit sogenannten hyperabruptem PN-Übergang keine ausreichend linearen Nachsteuerkennlinien. Erfindungsgemäß wird deshalb ein Oszillator vorgeschlagen, dessen spannungsgesteuerte Reaktanz eine Stromspiegelschaltung enthält. Derartige Oszillatoren können überall dort mit Vorteil verwendet werden, wo bei Frequenzen im genannten Frequenzbereich eine besonders lineare Nachsteuerkennlinie gefordert wird.

FIG 1

Nachstimmbarer LC-Oszillator mit spannungsgesteuerter
Reaktanz

Die Erfindung betrifft einen nachstimmbaren LC-Oszillator
mit spannungsgesteuerter Reaktanz und mit einem emittergekoppelten Differenzverstärker.

Nachstimmbare LC-Oszillatoren, bei denen die Schwingkreiskapazität wenigstens zum Teil durch die spannungsabhängige Sperrschichtkapazität einer Diode mitbestimmt
wird, sind allgemein bekannt. In einer Reihe von Anwendungsfällen, beispielsweise beim Einsatz derartiger
Oszillatoren in signalverarbeitenden Phasenregelschleifen
ergibt sich die Notwendigkeit, daß eine symmetrische,
rechteckförmige Ausgangsspannung erzeugt wird und daß
die Nachsteuerkennlinie des Oszillators, also die Abhängigkeit deren Frequenzänderung von der Änderung der
Steuerspannung, streng linear ist. Bei der Anwendung im
Frequenzbereich von einigen 100 KHz bis zu einigen MHz
ergibt sich nun das Problem, das auch die Verwendung
von Kapazitätsdioden mit sogenanntem hyperabrupten PN-
Übergang keine ausreichend lineare Nachsteuerkennlinie
für den Oszillator ergibt. Die Aufgabe der Erfindung besteht also darin, einen Oszillator der eingangs erwähnten Art zu entwickeln, der bei Erzeugung einer
symmetrischen und rechteckförmigen Ausgangsspannung im
betrachteten Frequenzbereich eine besonders lineare
Nachsteuerkennlinie aufweist.

Erfindungsgemäß wird die Aufgabe dadurch gelöst, daß ein
erster Transistor vorgesehen ist, dessen Basisanschluß
mit Bezugspotential und dessen Emitteranschluß mit dem
Emitteranschluß eines zweiten Transistors und über einen
ersten Widerstand mit einer negativen Betriebsspannungs-

19.7.83/Ah 1 Seu

0132749

VPA 83 P 1 5 0 0 .E

quelle verbunden ist, daß der Kollektoranschluß des ersten Transistors über einen aus einem ersten Kondensator und einer Induktivität gebildeten Parallelschwingkreis mit einer positiven Betriebsspannungsquelle, direkt mit dem Kollektoranschluß eines dritten Transistors, über einen zweiten Kondensator mit dem Kollektor- und Basisanschluß eines vierten Transistors und über einen dritten Kondensator mit dem Basisanschluß des zweiten Transistor verbunden ist, daß dieser Basisanschluß über einen zweiten Widerstand mit Bezugspotential verbunden ist, daß die Emitteranschlüsse des dritten und des vierten Transistors mit Bezugspotential verbunden sind, daß der Kollektoranschluß des vierten Transistors außerdem über einen dritten Widerstand mit der positiven Betriebsspannungsquelle und über einen vierten Widerstand mit dem Basisanschluß des dritten Transistors verbunden ist, daß dieser Basisanschluß über einen fünften Widerstand mit einer Steuerspannungsquelle verbunden ist, daß der Kollektoranschluß des zweiten Transistors mit einem Ausgangsanschluß und außerdem über einen sechsten Widerstand mit der positiven Betriebsspannungsquelle verbunden ist.

Die erfindungsgemäße Schaltungsanordnung bietet den besonderen Vorteil, wegen des Verzichts auf Kapazitätsdioden und der Verwendung nur einer einzigen Induktivität leicht in monolithischer Technik herstellbar zu sein, so daß nur geringe Schwankungen der Parameter der verwendeten Transistoren zu erwarten sind. Damit ergibt sich eine hohe Symmetrie bei den auftretenden Umschaltvorgängen und damit bei der erzeugten Ausgangsspannung.

Zur rückwirkungsfreien Auskoppelung bzw. zur Verminderung des Einflusses von Schwankungen des externen Lastwiderstandes auf die Oszillatorstabilität wird eine Weiterbildung des erfindungsgemäßen Oszillators vorgeschlagen, bei der mit dem ersten Ausgangsanschluß über einen vierten Kondensator der Basisanschluß eines fünften Transistors verbunden ist, daß dieser Basisanschluß über einen siebten Widerstand mit Bezugspotential und über einen achten Widerstand mit dem Kollektoranschluß des fünften Transistors verbunden ist, daß dieser Kollektoranschluß mit einem zweiten Ausgangsanschluß und außerdem über einen neunten Widerstand mit der positiven Betriebsspannungsquelle verbunden ist und daß der Emitteranschluß des fünften Transistors an Bezugspotential angeschlossen ist.

Weitere zweckmäßige Ausbildungen des erfindungsgemäßen Oszillators sind in den Patentansprüchen 3 bis 7 beschrieben.

Die Erfindung wird im folgenden anhand der Zeichnung näher erläutert.

In der Zeichnung zeigt

Fig. 1 das Schaltbild des erfindungsgemäßen Oszillators und

Fig. 2 eine Reaktanzschaltung zur Schaltung nach Fig. 1.

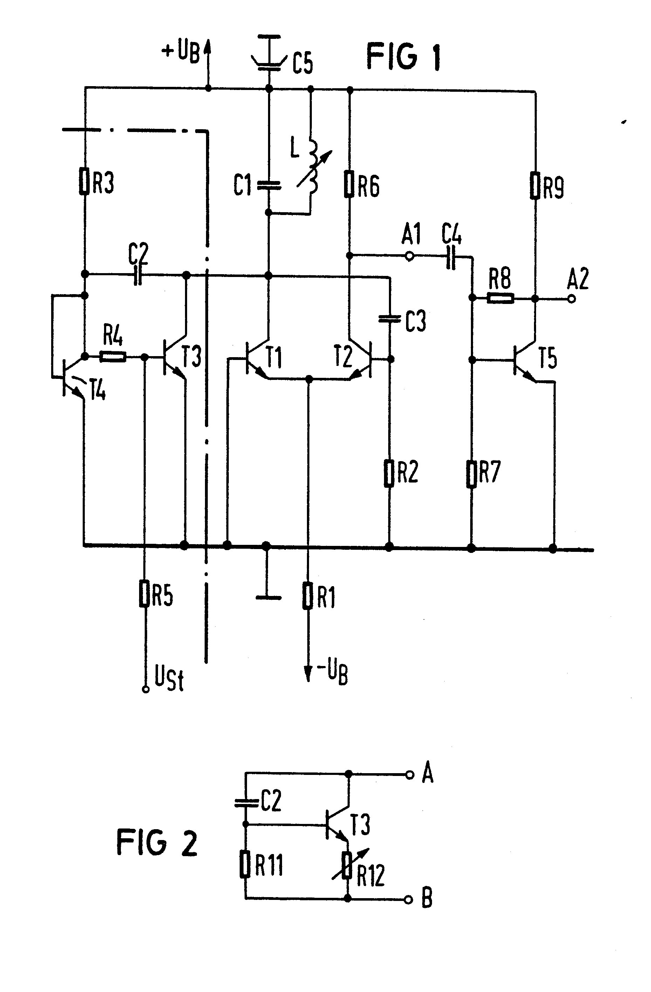

Der Oszillator nach der Fig. 1 enthält einen emittergekoppelten Differenzverstärker mit einem ersten und einem zweiten Transistor T1, T2, deren Emitteranschlüsse miteinander und über einen ersten Widerstand R1 mit einer negativen Betriebsspannungsquelle $-U_B$ verbunden ist. Der Basisanschluß des ersten Transistors T1 ist mit Bezugspotential verbunden, während dessen Kollektoranschluß über einen aus einer Induktivität L und einem ersten Kondensator C1 gebildeten Parallelschwingkreis mit einer positiven Betriebsspannungsquelle $+U_B$ und außerdem mit dem Kollektoranschluß eines dritten Transistors, über einen zweiten Kondensator C3 mit dem Basisanschluß des zweiten Transistors T2 verbunden ist. Der Basisanschluß des zweiten Transistors T2 ist außerdem über einen zweiten Widerstand R2 mit Bezugspotential verbunden. Die Emitteranschlüsse des dritten und des vierten Transistors T3, T4 sind an Bezugspotential angeschlossen, der Kollektoranschluß des vierten Transistors T4 ist außerdem über einen dritten Widerstand R3 mit der positiven Betriebsspannungsquelle +$U_B$ verbunden. Es besteht weiterhin eine Verbindung über den vierten Widerstand R4 zur Basis des dritten Transistors T3 und von dieser über einen fünften Widerstand R5 zu einer Steuerspannungsquelle $U_{St}$. Der Kollektoranschluß des zweiten Transistors ist mit einem ersten Ausgangsanschluß A1, über einen sechsten Widerstand R6 mit der positiven Betriebsspannungsquelle +$U_B$ und über einen vierten Kondensator C4 mit dem Basisanschluß eines fünften Transistors T5 verbunden. Der Emitteranschluß dieses Transistors ist an Bezugspotential angeschlossen, während der Basisanschluß zusätzlich über einen siebten Widerstand R7 mit Bezugspotential und über einen achten Widerstand R8 mit dem Kollektoranschluß dieses Transistors verbunden ist, dieser Kollektoranschluß ist außerdem mit einem zweiten Ausgangsanschluß A2 und über einen neunten Widerstand R9 mit der positiven Betriebsspannungsquelle +$U_B$ verbunden. Die Zuleitungen zur positiven Betriebsspannungsquelle sind über einen fünften Kondensator C5 wechselspannungsmäßig geerdet.

Zusätzlich zu den rückgekoppelten Differenzverstärkern mit den beiden Transistoren T1 und T2 enthält der Oszillator nach Fig. 1 eine steuerbare Reaktanz mit den Transistoren T3 und T4 sowie einen Trennverstärker mit dem Transistor T5. Der über den Widerstand R1 von der negativen Betriebsspannungsquelle den Emitteranschlüssen des ersten und des zweiten Transistors zugeführte Strom $I_0$ wird durch die sinusförmige Schwingkreisspannung, die über den dritten Kondensator C3 an den Basisanschluß des

0132749

zweiten Transistors gekoppelt wird, rechteckförmig und
symmetrisch zwischen den beiden Transistoren umgeschaltet.
Der Grundwellenanteil dieses rechteckförmigen Stromes
erzeugt dabei am Schwingkreis die sinusförmige Schwingspannung. Dieser Schaltvorgang ist symmetrisch, sofern
die Offsetspannung der Transistoren T1 und T2 sowie der
Spannungsabfall durch den Basistrom des zweiten Transistors am zweiten Widerstand R2 hinreichend klein sind
gegenüber dem Scheitelwert der Schwingkreisspannung.

Bei einem Aufbau in integrierter Technik oder zumindest
bei der Verwendung eines monolithischen Transistor arrays
ist diese Forderung nach kleinem Offset leicht zu erfüllen.
Der den Schwingkreis bedämpfende zweite Widerstand R2
wird dabei so groß gewählt, daß der Spitze-Spitze-Wert
der Schwingamplitude am Schwingkreis das zehn- bis
dreißigfache der Temperaturspannung des Transitors,
also zwischen 0,25 und 0,75 Volt, beträgt. In diesem Bereich ergibt sich ein optimaler sättigungsfreier Schaltbetrieb. Die Rückwirkung einer externen Last auf den
Oszillator ist durch eine mit dem Transistor T5 aufgebaute
Trennstufe erheblich verringert. Dies wird erreicht
durch den mittels des Gegenkopplungswiderstandes R8
sehr niederohmigen Eingangswiderstand der Trennstufe,
durch den sich an dieser Stelle praktisch ein virtueller
Nullpunkt ergibt. Dadurch wird die Kollektorwechselspannung des zweiten Transistors T2 sehr klein, sodaß
Spannungseinflüsse über die Rückwirkungskapazität zwischen
Kollektor und Basis dieses Transistors keinen wesentlichen
Einfluß auf die Frequenz der erzeugten Schwingungen haben.
Der Kollektorwiderstand R6 am zweiten Transistor T2 und
der Basiswiderstand R7 am fünften Transistor T5 sind vergleichsweise groß gegenüber dem dynamischen Eingangswiderstand am Basisanschluß des Transistors T5 gewählt,
so daß die erzeugte Rechteckspannung am Ausgang A2 etwa
dem Spannungsabfall des Stromes Io durch den Widerstand
R8 entspricht. Die Trennstufe kann dadurch eine TTL-kompatible
Ausgangsspannung erzeugen.

Zur Erläuterung der steuerbaren Raktanzschaltung mit den Transistoren T3 und T4 wird auf die Figur 2 verwiesen. In dieser Schaltung ist mit R11 der Bahnwiderstand durch den Transistor T4 bezeichnet, während der Widerstand R12 ein Ausdruck für die inverse Steilheit des Transistors T3 darstellt. Unter der Voraussetzung, daß der Widerstand R11 sehr klein gegenüber dem kapazitiven Widerstand des Kondensators C2 ist, gilt als Näherung, daß die Spannung am Widerstand R11 der Klemmenspannung zwischen A und B um 90 Grad voreilt und damit auch der Kollektorstrom des Transistors T3. Der tatsächliche Blindstrom dieser Anordnung kann dann ein mehrfaches des Stroms durch den Kondensator C2 sein, dies ist vom Verhältnis der Widerstand R11 und R12 zueinander abhängig. Wird einer der beiden Widerstände, also beispielsweise der Widerstand R12 variabel ausgeführt, dann ändert sich der Blindstrom der Anordnung, sodaß sich damit die Wirkung einer steuerbaren Kapazität ergibt.

Damit diese wirksam bleibt, muß der über R3 dem als Diode geschalteten Transistor T4 zugeführte Gleichstrom immer größer als die Wechselstromamplitude des über C2 zugeführten Stromes sein. Der kapazitive Widerstand des Kondensators C2 muß außerdem deutlich größer sein als der differentielle Widerstand zwischen Kollektor und Emitter des Transistors T4, der sich als Quotient der Temperaturspannung (beispielsweise 26mV) und des Emitterstroms dieses Transistors ergibt. Die Kollektor-Emitterspannung des Transistors T4 enthält damit einen Wechselspannungsanteil, der dem Logarithmus des Blindstroms durch den Kondensator C2 proportional ist. Die Emitter-Basis-Strecke des Transistors T3 wird damit in der Art einer Stromspiegelschaltung ausgesteuert. Der erzeugte Kollektorstrom ist wegen der exponentiellen Ansteuerkennlinie des Transistors T3 ein unverzerrtes Abbild des Stromes durch den Kondensator C2. Über den Spannungsteiler R5, R4 wird nun eine Steuerspannung zugeführt, die als

0132749

variable Offsetspannung wirkt und durch die der Spiegelungsfaktor der Stromspiegelschaltung und damit die wirksame Kapazität eingestellt werden kann. Der Widerstand R4 ist dabei kleiner als der Eingangswiderstand des Transistors T3, der Wert des Widerstandes R5 ist wegen dessen Wirkung als Entkoppelwiderstand etwa um den Faktor 100 größer als der des Widerstandes R4. Die benötigte Steuerspannung $U_{St}$ liegt dann in einem für TTL-Schaltungen üblichen Bereich.

7 Ansprüche
2 Figuren

Patentansprüche

1. Nachstimmbarer LC-Oszillator mit spannungsgesteuerter Reaktanz und mit einem emittergekoppelten Differenzverstärker, d a d u r c h g e k e n n z e i c h n e t , daß ein erster Transistor (T1) vorgesehen ist, dessen Basisanschluß mit Bezugspotential und dessen Emitteranschluß mit dem Emitteranschluß eines zweiten Transistors (T2) und über einen ersten Widerstand (R1) mit einer negativen Betriebsspannungsquelle (-U$_B$) verbunden ist, daß der Kollektoranschluß des ersten Transistors (T1) über einen aus einem ersten Kondensator (C1) und einer Induktivität (L) gebildeten Parallelschwingkreis mit einer positiven Betriebsspannungsquelle (+U$_B$), direkt mit dem Kollektoranschluß eines dritten Transistors (T3), über einen zweiten Kondensator (C2) mit dem Kollektor- und Basisanschluß eines vierten Transistors (T4) und über einen dritten Kondensator (C3) mit dem Basisanschluß des zweiten Transistors (T2) verbunden ist, daß dieser Basisanschluß über einen zweiten Widerstand (R2) mit Bezugspotential verbunden ist, daß die Emitteranschlüsse des dritten und des vierten Transistors (T3, T4) mit Bezugspotential verbunden sind, daß der Kollektoranschluß des vierten Transistors (T4) außerdem über einen dritten Widerstand (R3) mit der positiven Betriebsspannungsquelle (+U$_B$) und über einen vierten Widerstand (R4) mit dem Basisanschluß des dritten Transistors (T3) verbunden ist, daß dieser Basisanschluß über einen fünften Widerstand (R5) mit einer Steuerspannungsquelle (U$_{St}$) verbunden ist, daß der Kollektoranschluß des zweiten Transistors (T2) mit einem Ausgangsanschluß (A1) und außerdem über einen sechsten Widerstand (R6) mit der positiven Betriebsspannungsquelle (+U$_B$) verbunden ist.

2. Nachstimmbarer LC-Oszillator nach Patentanspruch 1, d a d u r c h g e k e n n z e i c h n e t , daß mit dem

0132749

ersten Ausgangsanschluß (A1) über einen vierten Kondensator (C4) der Basisanschluß eines fünften Transistors (T5) verbunden ist, daß dieser Basisanschluß über einen siebten Widerstand (R7) mit Bezugspotential und über einen achten Widerstand (R8) mit dem Kollektoranschluß des fünften Transistors (T5) verbunden ist, daß dieser Kollektoranschluß mit einem zweiten Ausgangsanschluß (A2) und außerdem über einen neunten Widerstand (R9) mit der positiven Betriebsspannungsquelle (+Ub) verbunden ist und daß der Emitteranschluß des fünften Transistors (T5) an Bezugspotential angeschlossen ist.

3. Nachstimmbarer LC-Oszillator nach Patentanspruch 1, d a d u r c h   g e k e n n z e i c h n e t , daß der Wert des zweiten Widerstandes (R2) so groß gewählt ist, daß der Spitze-Spitze-Wert der Schwingamplitude am Schwingkreis das zehn- bis dreißigfache der Temperaturspannung beträgt.

4. Nachstimmbarer LC-Oszillator nach Patentanspruch 2, d a d u r c h   g e k e n n z e i c h n e t , daß die Widerstandswerte des sechsten und des siebten Widerstandes (R6, R7) gegenüber dem dynamischen Eingangswiderstand an der Basis des fünften Transistors T5 vergleichsweise groß sind.

5. Nachstimmbarer LC-Oszillator nach Patentanspruch 1, d a d u r c h   g e k e n n z e i c h n e t , daß der Widerstandswert des vierten Widerstandes (R4) klein gegenüber dem Eingangswiderstand des dritten Transistors (T3) ist.

6. Nachstimmbarer LC-Oszillator nach Patentanspruch 1, d a d u r c h   g e k e n n z e i c h n e t , daß der Widerstandswert des fünften Widerstandes (R5) etwa um den Faktor 100 größer als der des vierten Widerstandes (R4) ist.

7. Nachstimmbarer LC-Oszillator nach Patentanspruch 1, **d a d u r c h   g e k e n n z e i c h n e t** , daß der Widerstandswert des dritten Widerstandes (R3) so klein gewählt ist, daß der Gleichstrom durch diesen Widerstand größer als der Maximalwert des Stromes durch den zweiten Kondensator (C2) ist.

FIG 1

FIG 2